# EUROPÄISCHE PATENTSCHRIFT

(11) **EP 0 351 658 B1**
(45) Veröffentlichungstag und Bekanntmachung des Hinweises auf die Patenterteilung: **27.10.1993**
(21) Anmeldenummer: 89112376.2
(22) Anmeldetag: 06.07.1989
(51) Int. Cl.: G11C 17/00, G11C 29/00, G11C 16/06

(54) **Verfahren zum Schutz von Schaltungsanordnungen mit als Zähler eingesetztem elektrisch programmierbarem nichtflüchtigem Speicher vor grenzwertiger, nicht eindeutiger Programmierung dieses Speichers und Schaltungsanordnung zur Durchführung des Verfahrens**
Method for protecting circuit arrangements comprising an electrically programmable non-volatile memory used as a counter of marginal, not well-defined programming of this memory, and circuitry for carrying out this method
Méthode de protection des circuits comprenant une mémoire non volatile programmable électriquement utilisée comme compteur contre la programmation non explicite à limite des tolérances de cette mémoire et agencement de circuit pour la mise en oeuvre de cette méthode

(30) Priorität: 20.07.1988 DE 3824674
(43) Veröffentlichungstag der Anmeldung: 24.01.1990
(73) Patentinhaber: SIEMENS AKTIENGESELLSCHAFT, 80333 München (DE)
(72) Erfinder: Schrenk, Hartmut, Dr., D-8013 Haar (DE)

(56) Entgegenhaltungen:
- EP-A- 0 207 320
- EP-A- 0 214 390
- WO-A-86/06205
- US-A- 4 460 982

## Beschreibung

Die Erfindung betrifft ein Verfahren zum Schutz von Schaltungsanordnungen mit elektrisch programmierbarem nichtflüchtigem Speicher, der als nichtflüchtiger Zähler eingesetzt ist, vor grenzwertiger, nicht eindeutiger Programmierung des den Zähler bildenden Speicherbereiches nach dem Oberbegriff des Patentanspruchs 1 sowie eine Schaltungsanordnung zur Durchführung des Verfahrens nach dem Oberbegriff des Patentanspruchs 3.

Integrierte Schaltungen mit einem elektrisch programmierbaren nichtflüchtigen Speicher vom E-PROM- oder EE-PROM-Typ werden bekanntlich auf Chipkarten eingesetzt. Als Schutz gegen einen Mißbrauch der Chipkarten verfügen sie häufig über eine Sicherheitslogik, die bestimmte Benutzer funktionen wie Auslesen, Schreiben, Löschen oder Vergleichen des Speicherinhalts von der Anwendung eines chipinternen Datenvergleichs zwischen nichtflüchtig im Speicher abgelegten Codedaten mit geheimen Kontrolldaten abhängig macht, die beispielsweise von einem Benutzer in einem Terminal einzugeben sind. Es ist in vielen Fällen erwünscht, aus Sicherheitsgründen jede Anwendung dieses Geheimcodes erkennbar zu machen, um auch im Falle eines Verrats oder Mißbrauchs des Geheimcodes die Kontrolle über den Speicherzugriff zu behalten. Dadurch ist es möglich, eine unberechtigte Benutzung zu erkennen und die Anzahl unbefugter Benutzungsversuche zu begrenzen.

Aus der DE-PS 26 21 269 ist eine Datenträgeranordnung mit einem Datenspeicher bekannt, wobei das Einschreiben von Daten in den Datenspeicher bzw. das Auslesen von Daten aus dem Datenspeicher nur nach positivem Vergleich eines in einem Code-Datenspeicher der Datenträgeranordnung abgespeicherten Codes mit einem gesondert einzugebenden Kontrollcode ermöglicht ist und wobei das Auslesen des im Code-Datenspeicher enthaltenen Codes zur Vergleichereinrichtung möglich ist, das Ändern des Code-Datenspeicherinhaltes jedoch unterbunden ist.

Aus der DE-OS 33 15 047 ist beispielsweise eine integrierte Schaltung bekannt, bei der das Löschen eines EE-PROM-Speicherbereiches nichtflüchtig und stets erkennbar in einem nichtflüchtig registrierenden Zähler abgelegt bleibt.

Aus der EP-OS 0 128 362 ist eine Schaltungsanordnung mit Speicher und Sicherheitslogik bekannt, bei der die Benutzungsberechtigung durch Eingabe von Kontrolldaten nachgewiesen werden muß. Diese Kontrolldaten werden in der Schaltungsanordnung mit abgespeicherten Codedaten verglichen und die Benutzungsberechtigung vom korrekten Datenvergleich abhängig gemacht. Um eine Entdeckung des Geheimcodes durch häufiges Probieren zu unterbinden, ist die Sicherheitslogik so ausgelegt, daß jeder Versuch in einem in Form eines Fehlerzählers eingesetzten Speicher registriert wird, dessen Zählumfang die Anzahl der möglichen fehlerhaften Zugriffsversuche begrenzt. Ein Löschen der entsprechenden Speicherzellen bzw. ein Rücksetzen dieses Zählers ist nur nach einer korrekten Kontrolldaten-Eingabe möglich.

Bei Schaltungen nach der DE-OS 33 15 047 ist die Zahl der Zugriffsversuche insgesamt, bei Schaltungen nach der EP-OS 0 128 362 ist die Zahl der Zugriffsversuche mit falschen Kontrolldaten durch den Zählerumfang eines Kontrollzählers begrenzt. Um in betrügerischer Weise den Geheimcode einer solchen Schaltungsanordnung durch Probieren zu ergründen, ist also eine Manipulation des Zählerspeichers anzustreben. Bei entwertbaren Schaltungsanordnungen mit nichtflüchtigem Datenspeicher, wie z.B. Debit-Chipkarten, ist auch eine direkte Manipulation des nichtflüchtigen Datenspeichers dieser Schaltungsanordnung für einen Betrüger interessant.

Eine solche Manipulation ist dadurch erreichbar, daß Bits in einem nichtflüchtigen Speicher, insbesondere einem Datenspeicher oder einem Zählerspeicher, so grenzwertig programmiert werden, daß sie in Abhängigkeit von Betriebsparametern wie Spannung, Temperatur etc. entweder als "Null" oder als "Eins" erscheinen. Eine solche grenzwertige, nicht eindeutige Programmierung ist beispielsweise durch Herabsetzen der Programmierspannung oder der Programmierzeit prinzipiell möglich.

Durch grenzwertig programmierte Zählerbits, die sowohl als "Null" als auch als "Eins" ausgewertet werden können, ist eine Umgehung der durch den Zählumfang eines Freigabezählers oder Fehlerzählers bedingten Beschränkung der Anzahl der Zugriffsversuche, wie sie in Schaltungen nach der DE-OS 33 15 047, der EP-OS 0 128 362, der EP-OS 0 127 809, der EP-OS 0 224 639 oder der EP-OS 0 214 390 vorgesehen sein können, möglich.

Speziell bei der Chipkartenanwendung, wenn sich ein betrügerischer Benutzer der Karte durch Manipulation von Verbrauchseinheiten oder Löschvorgängen Vorteile verschaffen kann, stellt die grenzwertige Programmierung eine Sicherheitsschwachstelle dar.

Durch die Erzeugung von Programmierzeit bzw. Programmierspannung auf der die entsprechende Schaltungsanordnung beinhaltenden integrierten Schaltung läßt sich die Möglichkeit der direkten Beeinflussung eines Programmiervorganges einschränken. Ein solches Verfahren ist jedoch einerseits aufwendig und läßt andererseits doch noch zu viele Möglichkeiten der grenzwertigen Programmierung von Speicherbits offen.

Aufgabe der Erfindung ist die Bereitstellung eines Verfahrens zum Schreiben von Zähler-Speicherbits eines nichtflüchtigen Speichers, wobei die grenzwertige Programmierung von Speicherbits unterbunden ist sowie die Bereitstellung einer Schaltungsanordnung zur Durchführung des Verfahrens.

Diese Aufgabe wird durch ein Verfahren nach dem Patentanspruch 1 bzw. durch eine Schaltungsanordnung nach dem Patentanspruch 3 gelöst.

Günstige Ausgestaltungsformen sind Gegenstand von Unteransprüchen.

Ein Verfahren zum Unterbinden einer grenzwertigen Programmierung von Speicherzellen eines elektrisch programmierbaren, nichtflüchtigen Speichers ist dadurch gegeben, daß nach dem Programmieren einer jeden Speicherzelle der Inhalt dieser Zelle gelesen wird, wobei nur für den Fall, daß bei diesem Lesevorgang die entsprechende Speicherzelle als programmiert erkannt wird, ein Freigabesignal beispielsweise den Zugriff zu irgendeiner geschützten Funktion ermöglicht und wobei erfindungsgemäß bei diesem unmittelbar nach dem Programmiervorgang vorgesehenen Lesevorgang der Bewertungspegel kritischer eingestellt ist, als bei den sonstigen Lesevorgängen. Hierbei sollte die Differenz zwischen dem üblichen Lesepegel und dem Lesepegel, der unmittelbar nach dem Programmieren eines Bit zur Bewertung dieses Bit vorgesehen ist, möglichst mindestens so groß sein, wie die durch äußere Einflüsse erzielbare Pegelschwankung.

Es erweist sich als günstig, bei Vorliegen des kritischen Lesepegels in Abhängigkeit vom nächsten Bitadreßwechsel auf den normalen Lesepegel zu schalten.

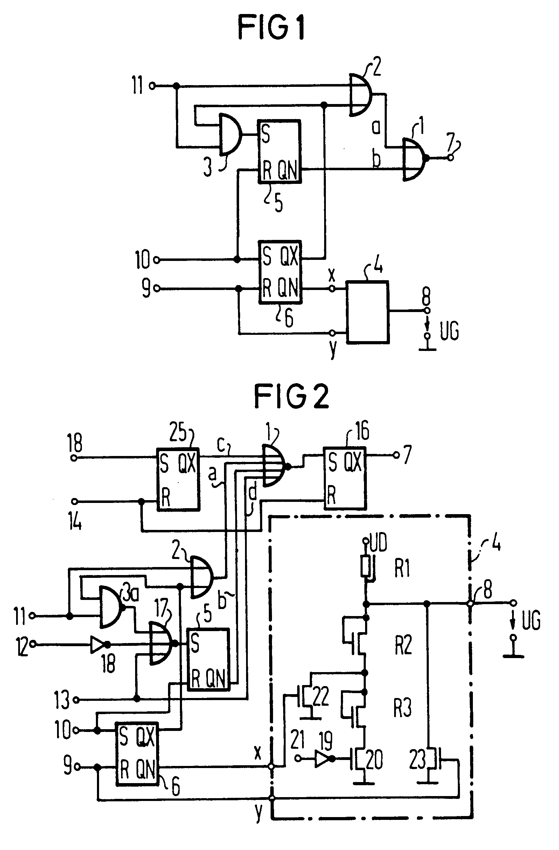

FIG 1 zeigt eine Logikschaltung, mit der erfindungsgemäß in Abhängigkeit vom Speicherinhalt, von einem Adreßwechsel-Signal und einem einen Programmiervorgang anzeigenden Signal verschiedene Bewertungspegel einstellbar sind bzw. ein Freigabesignal erzeugt werden kann, wobei eine Pegelumschalteinrichtung 4 im Blockschaltbild dargestellt ist.

FIG 2 zeigt ein besonders günstiges Ausführungsbeispiel einer Logikschaltung nach FIG 1, wobei zusätzliche Eingangsgrößen das Freigabesignal beeinflussen sowie eine mögliche Ausgestaltungsform einer Pegelumschalteinrichtung 4 für den Fall, daß der elektrisch programmierbare nichtflüchtige Speicher vom EE-PROM-Typ ist.

Anhand der Figuren werden nachstehend Ausführungsformen erfindungsgemäßer Schaltungsanordnungen zur Durchführung des Verfahrens in ihrem Aufbau und ihrer Funktionsweise beschrieben.

FIG 1 zeigt eine Logikschaltung mit einer Pegelumschalteinrichtung 4, wobei die Logikschaltung unter anderem aus einem Setzgatter 1 besteht, das im Ausführungsbeispiel als NOR-Gatter ausgebildet ist, dessen Ausgang den Freigabesignalausgang 7 bildet, dessen erster Eingang a mit der Ausgangsgröße eines ersten OR-Gatters 2 beaufschlagt ist und dessen zweiter Eingang b mit dem das invertierte Ausgangssignal führenden Ausgang QN eines Zählbit-Flipflops 5 verbunden ist. Ein Eingang des ersten OR-Gatters 2 ist mit einer mit einem vom Speicherinhalt der der angewählten Speicheradresse entsprechenden Speicherzelle abhängigen Signal beaufschlagten Eingangsklemme 11 und mit einem Eingang eines Kontroll-Logikgatters 3 verbunden. Der andere Eingang des ersten OR-Gatters 2 ist mit einem anderen Eingang des besagten Kontroll-Logikgatters 3 und mit dem das nichtinvertierte Signal führenden Ausgang QX eines Pegel-Flipflops 6 zusammengeschaltet. Das Ausgangssignal des im in der FIG 1 dargestellten Ausführungsbeispiel als AND-Gatter vorgesehenen Kontroll-Logikgatters 3 dient zur Beaufschlagung des Set-Einganges S des Zählbit-Flipflops 5. Der Reset-Eingang R des ZählbitFlipflops 5 ist gemeinsam mit dem Set-Eingang S des Pegel-Flipflops 6 an eine Eingangsklemme 10 angeschlossen, die mit einem vom Adreßwechsel abhängigen Signal derart beaufschlagt wird, daß jeder Adreßwechsel zum Zurücksetzen des Zählbit-Flipflops 5 und zum Setzen des Pegel-Flipflops 6 führt. Der das invertierte Ausgangssignal führende Ausgang QN des Pegel-Flipflops 6 ist mit einem ersten Steuereingang x der Pegelumschalteinrichtung 4 verbunden, über den der am Ausgang 8 der Pegelumschalteinrichtung 4 anstehende Bewertungspegel UG kritischer, als im normalen Bewertungsfall eingestellt wird. Der Reset-Eingang R des Pegel-Flipflops 6 ist an eine Eingangsklemme 9 geschaltet, die mit einem von einem Programmiervorgang abhängigen Signal derart angesteuert wird, daß bei einem Programmiervorgang das Pegel-Flipflop 6 zurückgesetzt wird. Insbesondere kann diese Eingangsklemme 9 in Abhängigkeit vom Aufbau der vorgesehenen Pegelumschalteinrichtung 4 zusätzlich mit einem zweiten Steuereingang y der Pegelumschalteinrichtung 4 verbunden sein, wobei durch Aktivierung der Pegelumschalteinrichtung 4 über diesen zweiten Steuereingang y der Spannungspegel UG am Ausgang 8 der Pegelumschalteinrichtung 4 auf den für den Programmiervorgang erforderlichen Wert eingestellt wird. Wenn der nichtflüchtige Speicher beispielsweise aus einer EE-PROM-Flotoxzelle besteht, so wird der Ausgang 8 der Pegelumschalteinrichtung 4 üblicherweise an die Programmierleitung des Speichertransistors geschaltet und bei aktiviertem Steuereingang y ist der Ausgang 8 dann auf Bezugspotential geschaltet.

Nachstehend wird die Funktionsweise einer erfindungsgemäßen Logikschaltung nach FIG 1 für den Fall beschrieben, daß der als Zähler eingesetzte nichtflüchtige Speicher vom EE-PROM-Typ ist.

Bei einem Adreßwechsel, durch den eine Adresse des besagten, als Zähler eingesetzten Speicherbereichs angewählt wird, wird über die Eingangsklemme 10 das Zählbit-Flipflop 5 zurückgesetzt und das Pegel-Flipflop 6 gesetzt.

Am ersten Steuereingang x der Pegelumschaltung 4 steht dann ein Low-Signal und am zweiten Eingang des ersten OR-Gatters 2 sowie am damit verbundenen Eingang des Kontroll-Logikgatters 3 ein High-Signal.

Ist die angewählte Speicherzelle bereits programmiert, so steht an der Eingangsklemme 11 ein Low-Signal und eine Freigabe durch das Setzgatter 1 ist über das erste OR-Gatter 2 und über das Kontroll-Logikgatter 3 unterbunden. Ist die angewählte Speicherzelle noch nicht programmiert, so steht an der Eingangsklemme 11 ein High-Signal. Dadurch wird der Ausgang des Kontroll-Logikgatters, hier eines AND-Gatters, an High-Potential geschaltet, das Zählbit-Flipflop 5 gesetzt und somit der zweite Eingang b des Setzgatters 1 auf Low-Potential gelegt und solange gehalten, bis ein neuer Adreßwechsel vorgenommen wird.

Wird die angewählte Speicherzelle programmiert, so wird über die Eingangsklemme 9 das Pegel-Flipflop 6 zurückgesetzt. Über den High-Pegel am ersten Steuereingang x der Pegelumschalteinrichtung 4 wird der Bewertungspegel UG kritischer eingestellt. Außerdem wird über den Ausgang QX des Flipflops der zweite Eingang des ersten OR-Gatters 2 auf Low-Pegel gelegt. Wird bei einer unmittelbar nach dem Programmiervorgang vorgenommenen Bewertung des Speicherinhaltes, also noch vor einem Adreßwechsel, die angewählte Speicherzelle mit dem kritischeren Pegel als geschrieben bewertet, d.h., daß an Klemme 11 ein Low-Pegel erkannt wird, so schaltet das erste OR-Gatter 2 ein Low-Signal an den ersten Eingang a des Setzgatters 1 und am Freigabeausgang 7 steht ein High-Signal an.

Wird die angewählte Speicherzelle bei Bewertung mit dem kritischeren Pegel nicht als geschrieben erkannt, so ist eine Freigabe durch das erste OR-Gatter 2 und somit durch das Setzgatter 1 unterbunden.

Bei der in FIG 2 gezeigten Ausführungsform ist ein Setzgatter 1 mit mehreren Eingängen vorgesehen. Außerdem ist dem Setzgatter 1 ein Freigabe-Flipflop 16 derart nachgeschaltet, daß der Ausgang des Setzgatters 1 mit dem Set-Eingang S des Freigabe-Flipflops 16 verbunden ist, daß ein Ausgang des Freigabe-Flipflops 16 das Freigabesignal an dem Freigabesignalausgang 7 bereitstellt und daß der Reset-Eingang R des Freigabe-Flipflops 16 gemeinsam mit dem Reset-Eingang R eines Fehler-Flipflops 25 an eine mit einem Rücksetzsignal zu beaufschlagende Klemme 14 angeschlossen ist. Ein Ausgang dieses Fehler-Flipflops 25 ist mit einem Eingang c des Setzgatters 1 verbunden und der Set-Eingang S dieses Fehler-Flipflops 25 wird über eine Klemme 18 mit einem Signal derart beaufschlagt, daß ein fehlerhafter Datenvergleich, beispielsweise ein Vergleich von Codedaten mit nicht übereinstimmenden Kontrolldaten, durch Setzen des Fehler-Flipflops 25 über das Setzgatter 1 ein Setzen des Freigabe-Flipflops 16 verhindet wird.

Ein Eingang d des Setzgatters 1 ist mit der als Enable-Eingang vorgesehenen Klemme 13 verbunden. Die Klemme 13 wird mit einem Setzfreigabesignal, üblicherweise einem Taktsignal, beaufschlagt, das die Freigabemöglichkeit auf die Zeiträume begrenzt, in denen feste Pegel am Speicherausgang zu erwarten sind. Durch diesen Schaltungsteil und das Setzfreigabesignal wird verhindert, daß das Freigabe-Flipflop 16 während eines Schreibvorganges aufgrund des nicht definierten Pegels gesetzt wird.

Das im Ausführungsbeispiel von FIG 1 als AND-Gatter 3 vorgesehene Kontroll-Logikgatter ist im Ausführungsbeispiel von FIG 2 als NAND-Gatter 3a ausgeführt, dessen Ausgang an einen Eingang eines weiteren NOR-Gatters 17 angeschlossen ist, wobei der Ausgang dieses NOR-Gatters 17 mit dem Set-Eingang S des Zählbit-Flipflops 5 verbunden ist. Ein zweiter Eingang des NOR-Gatters 17 ist an Klemme 13 angeschlossen. Dadurch ist das Setzen des Zählbit-Flipflops 5 nur möglich, wenn ein entsprechendes Setzfreigabesignal an Klemme 13 ansteht.

Als besonders günstig erweist sich, wenn ein weiterer vorzusehender Eingang des NOR-Gatters 17 insbesondere über einen Inverter 18 an eine Klemme 12 angeschlossen ist und wenn diese Klemme 12 mit einem Zähleradreßbit-Signal derart angesteuert wird, daß nur bei Anwahl einer zu schützenden Zähleradresse das Zählbit-Flipflop 5 über das NOR-Gatter 17 gesetzt werden kann.

Durch Strichpunktlinien eingerahmt ist in FIG 2 eine mögliche Ausgestaltungsform der Pegelumschalteinrichtung 4 gezeigt. Hierbei ist eine Versorgungsspannung UD über einen ersten Widerstand R1, üblicherweise einen entsprechend geschalteten Depletionmode-Feldeffekttransistor, an die Ausgangsklemme 8 geschaltet. Die Ausgangsklemme 8 ist außerdem über einen Schalter 23, üblicherweise einen Transistor, der über ein an der Klemme y anliegendes Signal angesteuert wird, gegen das Bezugspotential Masse schaltbar und mit einem Anschluß eines zweiten Widerstandes R2 verbunden. Der andere Anschluß dieses zweiten Widerstandes R2 ist über einen zweiten Schalter 22, üblicherweise einen Transistor, der über ein an der Klemme x anliegendes Signal angesteuert wird, gegen das Bezugspotential Masse schaltbar und außerdem über einen dritten Widerstand R3, der bedarfsweise in Serie mit einem dritten Schalter 20 liegt, ebenfalls gegen das Bezugspotential geschaltet. Der dritte Schalter 20 ist in diesem Falle von einem Löschsignal über eine Klemme 21 und insbesondere über einen Invertierer 19 angesteuert. Der zweite und dritte Widerstand R2 und R3 sind üblicherweise durch entsprechend geschaltete Feldeffekttransistoren realisiert. Bei einem Löschvorgang sind die drei Schalter 20, 22 und 23 offen bzw. die entsprechenden Transistoren gesperrt, so daß an der Ausgangsklemme 8 als Löschspannung UGL nahezu das Versorgungspotential UD anliegt, beispielsweise 20 V. Liegt an den Klemmen x, y und 21 ein Low-Pegel an, so sind die Schalter 22 und 23 offen und der Schalter 20 geschlossen. An der Ausgangsklemme 8 steht dann ein normaler Bewertungspegel UGN von beispielsweise 2 V an, mit dem Quotienten aus den Widerstandswerten (R2 + R3)/(R1 + R2 + R3) als Proportionalitätsfaktor. Liegt an der Klemme x High-Potential und an der Klemme y Low-Potential, so liegt der geschlossene Schalter 22 parallel zum dritten Widerstand R3, so daß dieser unwirksam ist. An der Ausgangsklemme 8 steht dann ein kritischerer Bewertungspegel UGK von beispielsweise 1,5 V an mit dem Quotienten aus den Widerstandswerten R2/(R1 + R2) als Proportionalitätsfaktor. Liegt an der Klemme y High-Potential, so ist die Ausgangsklemme 8 unabhängig vom Schaltzustand der Schalter 20 und 22 über den Schalter 23 auf Bezugspotential Masse geschaltet, was einem Programmierpegel UGP von ca. 0 V entspricht.

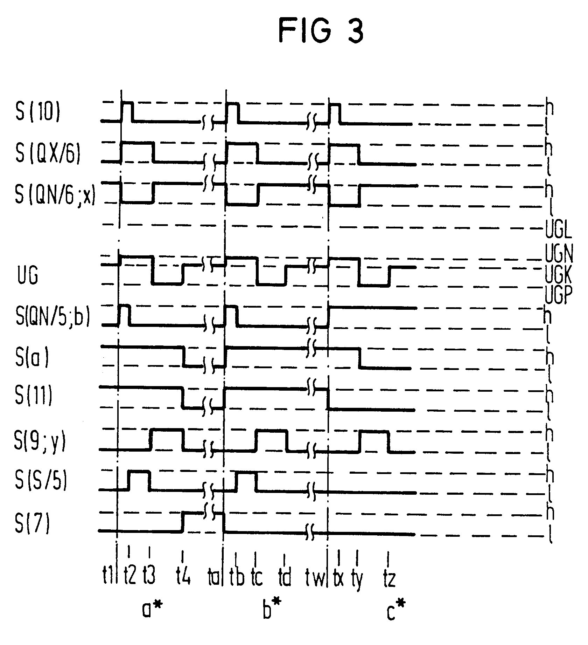

FIG 3 zeigt ein Pegeldiagramm, wobei das Pegelverhalten an zehn verschiedenen Meßpunkten einer Schaltung nach FIG 1 für verschiedene Eingangssignale gezeigt wird. Hierbei sind für die Logiksignale jeweils ein High-Pegel h und ein Low-Pegel 1 angedeutet und für den Pegel UG an der Ausgangsklemme 8 ist ein Löschpegel UGL, ein normaler Bewertungspegel UGN, ein kritischerer Bewertungspegel UGK und ein Programmierpegel UGP angedeutet. Dargestellt ist das Adreßwechselsignal S(10) an Klemme 10, das Signal S(QX/6) am Ausgang QX des Pegel-Flipflops 6, das invertierte Ausgangssignal S(QN/6;x) des Pegel-Flipflops 6, das auch an der Eingangsklemme x der Pegelumschalteinrichtung anliegt, der Ausgangspegel UG an der Ausgangsklemme 8, der Pegel S(QN/5;b) am das invertierte Ausgangssignal des Zählbit-Flipflops 5 führenden Ausgang QN, der auch am Eingang b des Setzgatters anliegt, das Signal S(a) am Eingang a des Setzgatters 1, das vom Inhalt der angewählten Speicherzelle abhängige Signal S(11) an der Eingangsklemme 11, das Programmiersignal S(9;y) an der Eingangsklemme 9, das auch an der Eingangsklemme y der Pegelumschalteinrichtugn 4 anliegt, das am Set-Eingang S des Zählbit-Flipflops 5 anstehende Signal S(S/5) sowie das am Freigabesignalausgang 7 anstehende Signal S(7).

Der Zeitbereich a* in FIG 3 zeigt die Pegelverläufe für den Fall, daß vom Zeitpunkt t1 bis zum Zeitpunkt t2 das Adreßwechselsignal an der Eingangsklemme 10 durch High-Pegel einen Adreßwechsel anzeigt, wobei die dann angewählte Speicherzelle als unbeschrieben erkannt ist und deshalb an Klemme 11 ein High-Pegel ansteht, daß an der Klemme 9 vom Zeitpunkt t3 bis zum Zeitpunkt t4 infolge eines Programmiervorganges ein High-Pegel anliegt, daß ab dem Zeitpunkt t4 die angewählte Speicherzelle als geschrieben erkannt wird und deshalb an Klemme 11 ein Low-Pegel ansteht, was zu einem High-Pegel am Freigabesignalausgang 7 führt, weil sowohl am Eingang a als auch am Eingang b des Setzgatters 1 ab dem Zeitpunkt t4 Low-Potential anliegt.

Der Zeitbereich b* in FIG 3 zeigt die Pegelverläufe für den Fall, daß vom Zeitpunkt ta bis zum Zeitpunkt tb das Adreßwechselsignal an der Eingangsklemme 10 durch High-Potential einen Adreßwechsel anzeigt, daß die angewählte Speicherzelle als ungeschrieben erkannt wird und deshalb an Klemme 11 ein High-Pegel anliegt, daß an der Klemme 9 vom Zeitpunkt tc bis zum Zeitpunkt td infolge eines Programmiervorganges ein High-Pegel anliegt und daß nach dem Programmiervorgang, ab dem Zeitpunkt td, die angewählte Speicherzelle bei kritischer eingestelltem Bewertungspegel nicht als geschrieben erkannt wird und deshalb weiterhin an Klemme 11 ein High-Potential anliegt, wodurch am Eingang a des Setzgatters 1 weiterhin High-Potential anliegt und der Freigabesignalausgang 7 auf Low-Potential bleibt, also keine Freigabe erfolgt.

Der Zeitbereich c* in FIG 3 zeigt die Pegelverläufe für den fall, daß vom Zeitpunkt tw bis zum Zeitpunkt tx das Adreßwechselsignal an der Eingangsklemme 10 durch High-Pegel einen Adreßwechsel anzeigt, daß die angewählte Speicherzelle zum Zeitpunkt tw bzw. tx als geschrieben erkannt wird und deshalb unabhängig vom nachfolgenden Programmiervorgang am Eingang b des Setzgatters 1 ein High-Potential anliegt und somit der Freigabesignalausgang 7 auf Low-Potential bleibt, also keine Freigabe erfolgt.

Die Darstellung der Pegelverläufe in FIG 3 ist rein schematisch, es werden nur logische Zustände dargestellt, evtl. Schaltzeitverzögerungen sind nicht berücksichtigt.

## Patentansprüche

1. Verfahren zum Schutz vor zugriffen auf Schaltungsanordnungen mit einem in den Schaltungsanordnungen als nichtflüchtigen Zähler eingesetzten elektrisch programmierbaren nichtflüchtigen Speicher, wobei bei den Schaltungsanordnungen eine Zugriffskontrolle durch Vergleichen eines einzugebenden Kontrollcodes mit einem geheimen Code vorgesehen ist,
**dadurch gekennzeichnet,**
daß unmittelbar nach dem Programmieren eines jeden Zählerbits des nichtflüchtigen Zählers dieses Zählerbit bewertet wird, wobei die Freigabe eines Zugriffs davon abhängt, daß das Zählerbit als programmiert erkannt wird, und daß während dieser Bewertung des jeweiligen Zählerbits der Lesepegel kritischer eingestellt ist als bei allen späteren Lesevorgängen dieses Zählerbits, wobei der kritische Lesepegel so eingestellt ist, daß unvollständig programmierte Zählerbits als nicht programmiert erkannt werden.

2. Verfahren nach Anspruch 1,
**dadurch gekennzeichnet,**
daß zur kritischen Einstellung des Lesepegels ein Schalten zwischen zwei Pegeln vorgesehen ist, wobei mit der Einleitung des Schreibvorganges vom normalen Lesepegel zum kritischen Lesepegel umgeschaltet wird und mit dem nächsten Bitadressenwechsel auf den normalen Lesepegel zurückgeschaltet wird.

3. Schaltungsanordnung zur Durchführung eines Verfahrens nach Anspruch 1 oder 2,
**dadurch gekennzeichnet,**
daß die Schaltungsanordnung aus einem Pegel-Flipflop (6), einer Pegelumschalteinrichtung (4) mit einem Lesepegelausgang (8) und einer Logikschaltung (1, 2, 3, 5; 1, 2, 3a, 5, 16, 17) mit einem Freigabesignalausgang (7) besteht, daß der am Ausgang (8) der Pegelumschalteinrichtung (4) bereitgestellte Lesepegel in Abhängigkeit vom Schaltzustand des Pegel-Flipflops (6) normal oder kritischer einstellbar ist, daß bei jedem Programmiervorgang einer zu schützenden Speicherzelle ein Steuersignal für das Pegel-Flipflop (6) zum Einstellen des kritischeren Bewertungspegels am Ausgang (8) der Pegelumschalteinrichtung (4) vorgesehen ist und daß das Bereitstellen des Freigabesignals am Freigabesignalausgang (7) durch die Logikschaltung (1, 2, 3, 5; 1, 2, 3a, 5, 16, 17) vom logischen Zustand der angewählten Speicherzelle abhängt.

## Claims

1. Method for protecting against accesses to circuit configurations with an electrically programmable nonvolatile memory employed in the circuit configurations as nonvolatile counter, an access check being provided in the circuit configurations by comparison of a check code to be fed in with a secret code, characterised in that, immediately after the programming of each counter bit of the nonvolatile counter, this counter bit is evaluated, the enabling of access being dependent upon the condition that the counter bit is recognised as programmed, and in that, during this evaluation of the respective counter bit, the reading level is set more critically than in all subsequent processes of reading this counter bit, and the critical reading level being set so that incompletely programmed counter bits are recognised as not programmed.

2. Method according to Claim 1, characterised in that for the critical setting of the read level a switching between two levels is provided, in which method upon the initiation of the writing operation switching-over takes place from the normal reading level to the critical reading level and upon the next bit address change switching-back takes place to the normal reading level.

3. Circuit configuration for carrying out a method according to Claim 1 or 2, characterised in that the circuit configuration comprises a level flipflop (6), a level switch-over device (4) with a read-level output (8) and a logic circuit (1, 2, 3, 5; 1, 2, 3a, 5, 16, 17) with an enable signal output (7), in that the read-level prepared at the output (8) of the level switch-over device (4) can be set to be normal or more critical as a function of the switching condition of the level flipflop (6), in that on the occasion of each operation of programming a memory cell to be protected a control signal for the level flipflop (6) is provided for the setting of a more critical evaluation level at the output (8) of the level switch-over device (4), and in that the provision of the enable signal at the enable signal output (7) by the logic circuit (1, 2, 3, 5; 1, 2, 3a, 5, 16, 17) is dependent upon the logic state of the selected memory cell.

## Revendications

1. Procédé pour empêcher des accès à des montages comportant une mémoire non volatile électriquement programmable, prévue dans les montages en tant que compteur non volatil, selon lequel un contrôle d'accès est prévu dans les montages au moyen d'une comparaison d'un code de contrôle devant être introduit avec un code secret, caractérisé par le fait que juste après la programmation de chaque bit du compteur non volatil, ce bit est évalué, l'autorisation d'un accès dépendant du fait que le bit du compteur est identifié comme étant programmé, et que pendant cette évaluation du bit respectif du compteur, le niveau de lecture est réglé de manière qu'il soit plus critique que dans le cas de tous les processus de lecture ultérieurs de ce bit du compteur, le niveau de lecture critique étant réglé de manière que des bits du compteur, complètement programmés, sont identifiés comme n'étant pas programmés.

2. Procédé suivant la revendication 1, caractérisé par le fait que pour le réglage critique du niveau de lecture il est prévu une commutation entre deux niveaux, auquel cas une commutation est exécutée du niveau normal de lecture au niveau critique de lecture lors du déclenchement du processus d'enregistrement et une commutation en retour sur le niveau normal de lecture est effectuée lors de l'apparition du changement immédiatement suivant de l'adresse binaire.

3. Montage pour la mise en oeuvre d'un procédé suivant la revendication 1 ou 2, caractérisé par le fait que le montage est constitué par une bascule bistable (6) de réglage du niveau, par un dispositif de commutation de niveau (4) comportant une entrée (8) pour le niveau de lecture, et par un circuit logique (1,2,3,5; 1,2,3a,5,16,17) comportant une sortie (6) pour le signal de libération, que le niveau de lecture, qui est délivré à la sortie (8) du dispositif de commutation de niveau (4), peut être réglé sur un niveau normal ou critique en fonction de l'état de commutation de la bascule bistable (6) de réglage du niveau, que lors de chaque opération de programmation d'une cellule de mémoire devant être protégée, un signal de commande pour la bascule bistable (6) de réglage du niveau est prévu pour le réglage d'un niveau d'évaluation critique à la sortie (8) du dispositif de commutation de niveau (4), et que la délivrance du signal de libération au niveau de la sortie (7) prévue pour ce signal d'autorisation par le circuit logique (1,2,3,5; 1,2,3a, 5,16,17), dépend de l'état logique de la cellule de mémoire sélectionnée.
